# FASCICULE DE BREVET EUROPEEN

(11) **EP 0 542 648 B1**
(45) Date de publication et mention de la délivrance du brevet: **11.06.1997**
(21) Numéro de dépôt: 92420406.8
(22) Date de dépôt: 09.11.1992
(51) Int. Cl.: H01L 29/86

(54) **Composant semiconducteur de protection contre des surtensions**
Halbleiterbauelement zum Schutz gegen Überspannungen
Overvoltage protection semiconductor component

(30) Priorité: 15.11.1991 FR 9114445
(43) Date de publication de la demande: 19.05.1993
(73) Titulaire: SGS-THOMSON MICROELECTRONICS S.A., 94250 Gentilly (FR)
(72) Inventeur: Bernier, Eric, F-37100 Tours (FR)
(74) Mandataire: de Beaumont, Michel

(56) Documents cités:
- EP-A- 0 167 440
- DE-A- 2 833 917
- GB-A- 2 208 257

## Description

La présente invention concerne les composants semi-conducteurs de protection contre des surtensions, qui sont des éléments semiconducteurs qui deviennent passants dès que la tension à leurs bornes dépasse un seuil prédéterminé.

On considèrera ici plus particulièrement des composants du type thyristor sans gâchette (pour une protection unidirectionnelle) ou du type triac sans gâchette (pour une protection bidirectionnelle), c'est-à-dire des structures à quatre couches semiconductrices de types de conductivité alternés NPNP. Dans ces composants sans gâchette, la mise en conduction s'effectue par mise en avalanche locale de la jonction entre les couches centrales de la structure, cette avalanche se produisant généralement d'abord dans une zone locale puis s'étendant progressivement sur tout le volume du composant.

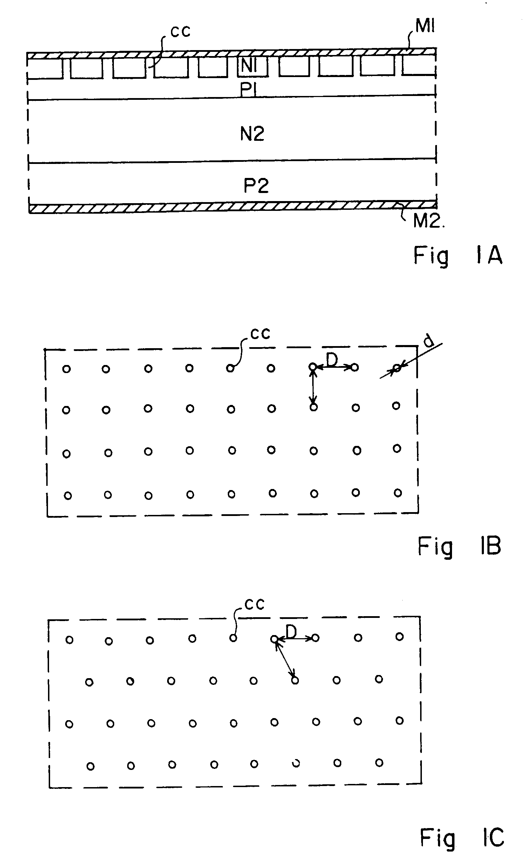

Comme le représente la figure 1A, un tel composant est constitué essentiellement par une superposition de couches semi-conductrices de types de conductivité alternés qui sont respectivement, entre une première face principale et une deuxième face principale, une couche de cathode N1 de type N, une couche de gâchette P1 de type P, une couche centrale N2 de type N, et une couche d'anode P2 de type P. Les couches de cathode et d'anode sont respectivement revêtues de métallisations M1 et M2. En général, la structure comporte des trous de "court-circuit" CC répartis sous la métallisation de cathode, trous par lesquels la couche de gâchette P1 remonte à travers la couche de cathode N1 jusqu'à la métallisation de cathode. Ces trous de court-circuit sont parfois appelés courts-circuits d'émetteurs.

Les figures 1B et 1C représentent des exemples de vues de dessus du composant de la figure 1A en l'absence de la métallisation M1 pour faire apparaître les courts-circuits CC. Ces figures représentent deux dispositions classiques de trous de court-circuit, respectivement en carré et en triangle ou en quinquonce. On caractérisé généralement ces trous par la distance D entre deux trous adjacents (en supposant que tous les trous sont équidistants) et par le diamètre d de chaque trou (en supposant que tous les trous ont le même diamètre).

Par ailleurs, on notera qu'à partir d'un composant de protection unidirectionnelle du type thyristor sans gâchette, tel qu'illustré en figure 1A, l'homme de l'art sait constituer un composant de protection bidirectionnelle du type triac sans gâchette en associant tête-bêche dans une même structure monolithique deux thyristors sans gâchette tels que celui de la figure 1A.

On notera en outre que les figures 1A, 1B et 1C sont des vues partielles et ne représentent notamment pas les bords du composant sur lesquels les dispositions habituelles seront prises au niveau des zones de découpe pour assurer les tenues en tension recherchées.

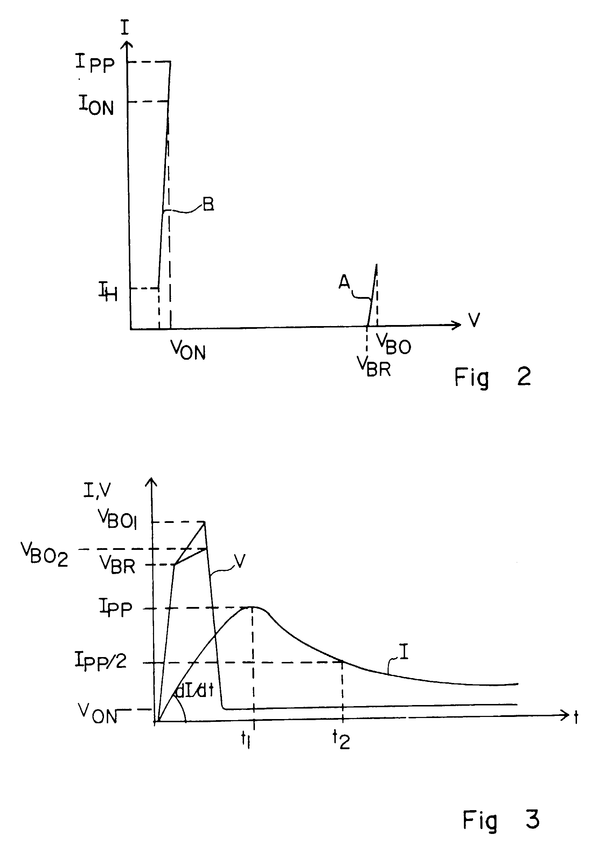

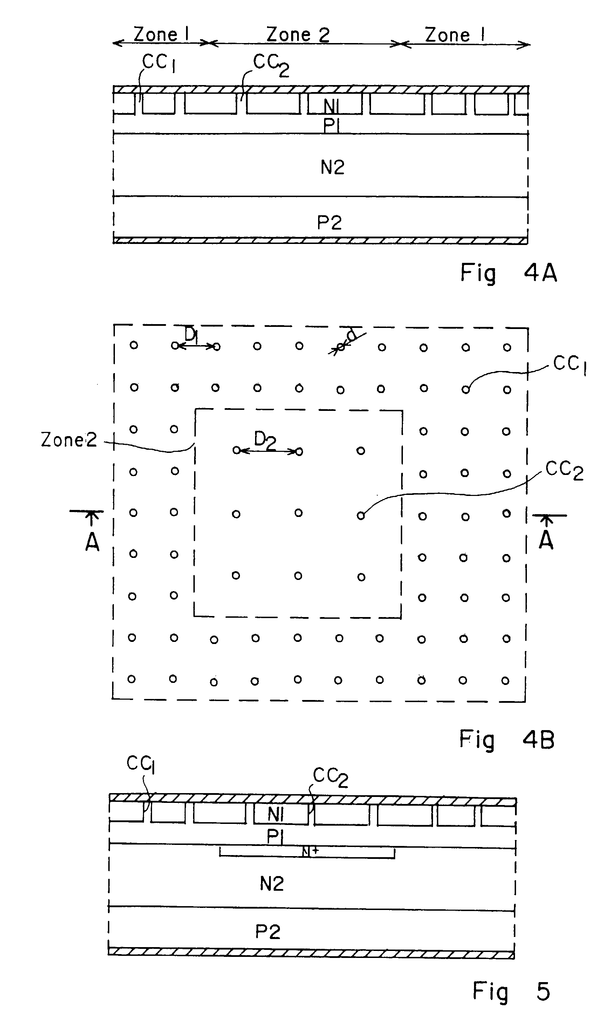

Les figures 2 et 3 représentent des courbes caractéristiques d'un composant de protection classique du type thyristor sans gâchette. Ces courbes correspondent à des composants unidirectionnels. Les caractéristiques de composants bidirectionnels s'en déduisent immédiamment par symétrie par rapport à l'origine.

La figure 2 représente l'allure du courant I en fonction de la tension V d'un thyristor sans gâchette classique. Tant que la tension appliquée reste inférieure à une valeur de seuil V_{BR}, le dispositif est bloquant et aucun courant ne circule. Quand une surtension apparaît et que la tension augmente entre la valeur V_{BR} et une valeur voisine V_{BO}, du courant commence à circuler dans le composant en suivant une caractéristique A. Quand la tension appliquée dépasse V_{BO}, on passe sur une courbe caractéristique B et le point de fonctionnement se fixe à une valeur de tension faible V_{ON} et à un courant I_{ON} déterminé par les caractéristiques de l'alimentation et du circuit. Ensuite, quand la surtension disparaît, le courant dans le composant décroît vers une valeur de courant de maintien I_{H} puis, quand le courant devient inférieur à cette valeur I_{H}, le composant se bloque à nouveau.

La caractéristique illustrée en figure 2 est illustrative des phénomènes statiques. La figure 3 représente l'allure du courant I et de la tension V en fonction du temps dans un composant du type thyristor sans gâchette soumis à une surtension. La tension passe très rapidement d'une valeur sensiblement nulle à la valeur V_{BR}. Puis, les phénomènes dynamiques font que la tension croît au-delà de la valeur V_{BO} avant de redescendre vers cette valeur puis vers la valeur V_{ON}. La croissance du courant se produit avec une pente initiale sensiblement linéaire désignée par dI/dt. Bien que les courbes de courant et de tension soient superposées, elles ne sont pas tracées selon la même échelle temporelle ; par exemple, la valeur V_{BO} sera atteinte en une durée inférieure à une microseconde, tandis que la durée t₁ au bout de laquelle le courant atteint une valeur maximale IPP peut être de l'ordre de 10 microsecondes et que la durée t₂ au bout de laquelle le courant a décru à la valeur IPP/2 peut être de l'ordre de 100 microsecondes

Parmi les caractéristiques importantes d'un composant de protection, on peut mentionner :
- l'écart entre les valeurs V_{BR} et V_{BO}, qui fixe la précision de déclenchement du dispositif ;
- le dépassement dynamique de la valeur V_{BO} qui doit être aussi réduit que possible ;
- la tenue en dI/dt qui doit être aussi élevée que possible, c'est-à-dire que le composant doit pouvoir supporter au démarrage des densités de courant élevées ;
- la valeur du courant de maintien I_{H} qui doit être relativement élevée. En effet, dans un composant de protection, on souhaite que, une fois que la surtension a disparu, le circuit couplé au composant de protection se remette à fonctionner aussi vite que possible. Si la valeur du courant de maintien I_{H} est trop faible, le composant de protection restera passant alors que la surtension s'est terminée.

Il est connu que la densité des trous de court-circuit a une influence sur ces divers paramètres. Notamment, si cette densité augmente, on obtient un effet favorable à savoir que le courant de maintien I_{H} augmente et des effets défavorables en ce que les valeurs de V_{BO} statiques et dynamiques augmentent et que la tenue en dI/dt diminue.

Ainsi, dans l'art antérieur, on a été amené à choisir des valeurs moyennes de densité de trous de court-circuit pour obtenir un compromis satisfaisant entre ces divers effets.

Par ailleurs, dans le domaine des thyristors ou triacs munis d'une gâchette de commande, on a été amené à modifier la densité des courts-circuits au voisinage de la zone de gâchette.

Un objet de la présente invention est de prévoir un composant de protection du type thyristor ou triac sans gâchette présentant des caractéristiques améliorées en ce qui concerne la réduction de la valeur V_{BO}, tant en statique qu'en dynamique, sans diminuer la valeur I_{H}.

Pour atteindre cet objet, la présente invention prévoit un composant de protection du type thyristor ou triac sans gâchette à trous de court-circuit, comprenant, en surface, une première zone ayant une première densité de trous de court-circuit et une deuxième zone ayant une deuxième densité de trous de court-circuit plus faible que la première.

Selon un mode de réalisation de la présente invention, ce composant comprend en outre une zone surdopée à l'interface entre sa couche centrale et sa couche de gâchette en regard de la deuxième zone.

Selon un mode de réalisation de la présente invention, tous les trous de court-circuit ont la même dimension et sont plus écartés dans la deuxième zone.

Selon un mode de réalisation de la présente invention, tous les trous de court-circuit sont au même pas et sont de plus petite dimension dans la deuxième zone.

Selon un mode de réalisation de la présente invention, ce composant comprend une première structure de trous de court-circuit à pas régulier et des trous de court-circuit supplémentaires dans la première zone, ces trous supplémentaires ayant un plus faible diamètre que les premiers.

Selon un mode de réalisation de la présente invention, la deuxième zone est disposée sensiblement au centre de la première.

Ces objets, caractéristiques et avantages ainsi que d'autres de la présente invention seront exposés en détail dans la description suivante de modes de réalisation particuliers faite en relation avec les figures jointes parmi lesquelles :
les figures 1A à 3, destinées à rappeler l'état de la technique et à faire ressortir le problème posé, ont été décrites précédemment ;
la figure 4A représente une vue en coupe schématique d'un composant de protection selon la présente invention ;
la figure 4B est une vue de dessus partielle du composant de la figure 4A qui en est une vue en coupe selon la ligne A-A ; et
la figure 5 représente une variante de réalisation de la présente invention.

Dans ces diverses figures, de mêmes notations désignent des éléments identiques ou analogues. En outre, comme cela est classique dans le domaine de la représentation des structures semiconductrices, les diverses vues en coupe ou de dessus des figures 1A à 1C et 4A à 5 ne sont pas tracées à l'échelle, les diverses épaisseurs et étendues de couches étant arbitrairement dilatées pour améliorer la lisibilité des figures.

Comme le représentent les figures 4A et 4B, la présente invention concerne un composant de protection du type thyristor sans gâchette, de façon générale analogue à celui illustré en figures 1A et 1B. Dans ce composant, on prévoit deux zones distinctes en surface dans lesquelles les densités de trous de court-circuit sont différentes. Dans la zone 1, la densité de trous de court-circuit CC1 est relativement élevée et dans la zone 2, elle est plus faible. De préférence, cette zone 2 est une zone centrale du dispositif.

La demanderesse a constaté que ces deux zones influent de façon séparée sur les caractéristiques susmentionnées. C'est la zone à faible densité de trous de court-circuit (CC2) qui fixe essentiellement les paramètres de mise en conduction du composant et donc qui permet de réduire les valeurs de V_{BO} en statique et en dynamique (on obtiendra la caractéristique correspondant à la valeur V_{BO2} illustrée en figure 2). Par contre, c'est la zone à plus forte densité de trous de court-circuit (CC1) qui déterminera l'ouverture du composant et donc qui fixera une valeur plus élevée de I_{H}. On obtient donc avec la présente invention une réduction des valeurs de V_{BO} en statique et en dynamique tout en conservant un courant de maintien I_{H} identique à celui d'une structure standard.

En figure 4B, on a représenté un mode de réalisation de l'invention dans lequel les trous de court-circuit ont tous le même diamètre d et sont espacés d'une distance D1 dans la zone 1 et d'une distance D2, supérieure à D1, dans la zone 2 dans une configuration similaire à celle de la figure 1B dans laquelle les trous sont agencés selon un motif carré. Ils pourraient également comme dans le cas de la figure 1C être agencés selon un motif triangulaire.

L'homme de l'art pourra prévoir diverses variantes de réalisation de l'invention, par exemple des trous dans la zone 2 au même pas que ceux de la zone 1 mais de plus petit diamètre ; ou bien des trous au même pas avec des trous supplémentaires dans la zone 1, éventuellement de plus petit diamètre...

Par ailleurs, les trous de court-circuit ne sont pas nécessairement circulaires.

La présente invention peut également se combiner avec divers perfectionnements connus de structures de thyristor sans gâchette. Par exemple, on pourra prévoir comme cela est représenté en figure 5 une zone de claquage préférentiel obtenue par une région N⁺ disposée à l'interface entre les régions P1 et N2. Dans ce cas, cette région N⁺ sera disposée dans la zone 2 où la densité de trous de court-circuit est plus faible. Alors, l'amorçage se faisant déjà en volume au voisinage de la région N⁺, la présente invention contribuera, pour un courant de maintien donné, à améliorer la tenue en énergie d'amorçage en réduisant la valeur de V_{BO} en statique et dynamique et le courant I_{BO} correspondant. Ceci est d'autant plus important que des surtensions susceptibles d'être appliquées sont courtes et donc que dI/dt et dV/dt sont importants.

## Revendications

1. Composant semiconducteur de protection contre des surtensions du type thyristor ou triac sans gâchette à trous de court-circuit, caractérisé en ce qu'il comprend, en surface, une première zone ayant une première densité de trous de court-circuit (CC1) et une deuxième zone ayant une deuxième densité de trous de court-circuit (CC2) plus faible que la première.

2. Composant selon la revendication 1, caractérisé en ce qu'il comprend en outre une zone surdopée à l'interface entre sa couche centrale et sa couche de gâchette en regard de la deuxième zone.

3. Composant selon la revendication 1, caractérisé en ce que tous les trous de court-circuit ont la même dimension et sont plus écartés dans la deuxième zone.

4. Composant selon la revendication 1, caractérisé en ce que tous les trous de court-circuit sont au même pas et sont de plus petite dimension dans la deuxième zone.

5. Composant selon la revendication 1, caractérisé en ce qu'il comprend une première structure de trous de court-circuit à pas régulier et des trous de court-circuit supplémentaires dans la première zone, ces trous supplémentaires ayant un plus faible diamètre que les premiers.

6. Composant selon la revendication 1, caractérisé en ce que la deuxième zone est disposée sensiblement au centre de la première.

## Patentansprüche

1. Halbleiterelement zum Schutz vor Überspannungen der gatelosen Thyristor- oder Triac-Bauart mit kurzschliessenden Löchern, dadurch gekennzeichnet, daß es an der Oberfläche eine erste Zone mit einer ersten Dichte von kurzschliessenden Löchern (CC1) und eine zweite Zone mit einer zweiten geringeren Dichte von kurzschliessenden Löcher (CC2) aufweist, wobei die zweite Dichte kleiner ist als die erste Dichte.

2. Element nach Anspruch 1, dadurch gekennzeichnet, daß es weiterhin eine überdotierte Zone an der Grenzschicht zwischen seiner Mittelschicht und seiner Gate-Schicht in Ausrichtung mit der zweiten Zone aufweist.

3. Element nach Anspruch 1, dadurch gekennzeichnet, daß alle genannten Kurzschluß-Löcher in der zweiten Zone die gleiche Größe aufweisen, aber mit größerem Abstand zu einander angeordnet sind

4. Element nach Anspruch 1, dadurch gekennzeichnet, daß alle genannten Löcher in der zweiten Zone den selben Rasterabstand besitzen und kleiner sind.

5. Element nach Anspruch 1, dadurch gekennzeichnet, daß es ein erstes Verteilungsmuster von Löchern aufweist, die den selben Rasterabstand besitzen und zusätzlich Löcher in genannter erster Zone aufweist, die einen kleineren Durchmesser haben als die erstgenannten.

6. Element nach Anspruch 1, dadurch gekennzeichnet, daß die genannte zweite Zone sich im wesentlichen in der Mitte der ersten Zone befindet.

## Claims

1. A semiconductor component for protection against overvoltages of the gateless thyristor or triac type with shorting holes, characterized in that it comprises, at the surface, a first zone having a first density of shorting holes (CC1) and a second zone having a second density of shorting holes (CC2) less than the first density.

2. A component according to claim 1, characterized in that it further comprises an overdoped zone at the interface between its middle layer and its gate layer in register with the second zone.

3. A component according to claim 1, characterized in that all said shorting holes have the same size and are disposed further away from each other in said second zone.

4. A component according to claim 1, characterized in that all of said shorting holes have the same pitch and are smaller in said second zone.

5. A component according to claim 1, characterized in that it comprises a first pattern of shorting holes having a regular pitch and additional shorting holes in said first zone, said additional holes having a smaller diameter than the first ones.

6. A component according to claim 1, characterized in that said second zone is disposed substantially in the middle of the first zone.
